(19) Europäisches Patentamt
European Patent Office
Office européen des brevets

(11) **EP 3 492 437 B1**

(12) **EUROPÄISCHE PATENTSCHRIFT**

(45) Veröffentlichungstag und Bekanntmachung des Hinweises auf die Patenterteilung:
**19.10.2022   Patentblatt 2022/42**

(21) Anmeldenummer: **18209131.4**

(22) Anmeldetag: **29.11.2018**

(51) Internationale Patentklassifikation (IPC):
*C03C 14/00* (2006.01)   *C03C 8/24* (2006.01)
*C03C 10/02* (2006.01)   *C03C 3/21* (2006.01)
*H01L 23/29* (2006.01)

(52) Gemeinsame Patentklassifikation (CPC):
**C03C 3/21; C03C 8/24; C03C 10/00; C03C 14/004; H01L 23/295;** C03C 2214/04

(54) **VERBUNDMATERIAL, UMFASSEND WENIGSTENS EIN ERSTES MATERIAL UND PARTIKEL, WOBEI DIE PARTIKEL EINEN NEGATIVEN THERMISCHEN AUSDEHNUNGSKOEFFIZIENTEN ALPHA AUFWEISEN, UND KLEBEMATERIAL UMFASSEND DAS VERBUNDMATERIAL**

COMPOSITE MATERIAL COMPRISING AT LEAST ONE FIRST MATERIAL AND PARTICLES, WHEREBY THE PARTICLES HAVE A NEGATIVE THERMAL EXPANSION COEFFICIENT ALPHA, AND ADHESIVE MATERIAL COMPRISING THE COMPOSITE MATERIAL

MATIÈRE COMPOSITE, COMPRENANT AU MOINS UNE PREMIÈRE MATIÈRE ET DES PARTICULES, LES PARTICULES AYANT UN COEFFICIENT ALPHA D'EXTRACTION THERMIQUE NÉGATIF, ET MATIÈRE ADHÉSIVE COMPRENANT LA MATIÈRE COMPOSITE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.12.2017   DE 102017128734**

(43) Veröffentlichungstag der Anmeldung:
**05.06.2019   Patentblatt 2019/23**

(73) Patentinhaber: **SCHOTT AG**
**55122 Mainz (DE)**

(72) Erfinder:
• **SCHUHMACHER, Joerg**
**70806 Kornwestheim (DE)**
• **TREIS, Philipp**
**55127 Mainz (DE)**
• **DREWKE, Jochen**
**55128 Mainz (DE)**
• **SCHMITT, Hans-Joachim**
**55437 Ockenheim (DE)**
• **HOVHANNISYAN, Martun**
**60598 Frankfurt/Main (DE)**
• **SIEBERS, Friedrich**
**55283 Nierstein (DE)**
• **MENKE-BERG, Yvonne**
**65197 Wiesbaden (DE)**

(74) Vertreter: **Sawodny, Michael-Wolfgang**
**Dreiköniggasse 10**
**89073 Ulm (DE)**

(56) Entgegenhaltungen:
**EP-A1- 3 360 848        DE-A1- 19 521 330**
**DE-A1-102014 220 457   DE-A1-102015 107 819**
**KR-A- 20140 080 183    US-A1- 2003 187 117**
**US-A1- 2008 012 156**

EP 3 492 437 B1

**Beschreibung**

Die Erfindung betrifft ein Verbundmaterial, umfassend wenigstens ein erstes Material und Partikel, wobei die Partikel einen negativen thermischen Ausdehnungskoeffizienten $\alpha$ aufweisen, und ein Klebematerial umfassend das Verbundmaterial.

Materialien mit geringer thermischer Dehnung sind bereits seit vielen Jahren Stand der Technik. Beispielsweise ist es bekannt, dass bestimmte kristalline Verbindungen, beispielsweise Cordierit, zumindest in bestimmten Richtungen im Kristallgitter eine sehr geringe Dehnung aufweisen, welche sogar negative Werte annehmen kann, d.h. ein aus einer solchen Verbindung aufgebauter Einkristall dehnt sich zumindest in einer bestimmten Raumrichtung bei Temperaturerhöhung nicht aus, sondern schrumpft. Es ist auch bekannt, Werkstücke herzustellen, welche Verbindungen mit niedriger thermischer Dehnung umfassen, sodass das Werkstück insgesamt eine sehr niedrige thermische Dehnung aufweist. Beispielsweise ist es bekannt, Cordierit-umfassende Werkstücke im Bereich von Abgaskatalysatoren einzusetzen.

Als in seiner Gesamtheit negativ dehnender Kristall ist $\beta$-Eukryptit bekannt. Beispielhaft beschreibt die US-Patentschrift US 6,506,699 B1 ein Material mit einem negativen thermischen Ausdehnungskoeffizienten, welches als Glaskeramik ausgebildet ist und verschiedene $SiO_2$-basierte Kristallphasen umfasst, insbesondere auch $\beta$-Eukryptit. Das Material wird über einen Schmelzprozess erhalten, wobei zunächst ein Glas erschmolzen wird und anschließend ein schnelles Abkühlen erfolgt. Anschließend erfolgt die Ausbildung einer glaskeramischen Phase aus dem Vorläuferglas, indem in einem weiteren thermischen Prozess eine Kristallisation erfolgt. Das in der US 6,506,699 B1 beschriebene Glas zeichnet sich dabei durch einen hohen Gehalt an $SiO_2$ aus, welcher zwischen 40 und 60 Gew.-% der Zusammensetzung beträgt. Das resultierende glaskeramische Material weist einen thermischen Ausdehnungskoeffizienten im Bereich zwischen $-2,5 \times 10^{-6}$/K bis $-100 \times 10^{-6}$/K im Temperaturbereich von -40°C bis +160°C auf.

Die US-amerikanische Patentschrift US 6,209,352 B1 beschreibt ein Verfahren zur Herstellung eines glaskeramischen Artikels, welches die folgenden Schritte umfasst: a) Herstellung eines Ausgangsglases, b) Wärmebehandlung des Ausgangsglases, sodass eine Glaskeramik mit anisotropen Kristallen erhalten wird, wobei diese Kristalle in mindestens einer Raumrichtung eine negative thermische Dehnung aufweisen und die durchschnittliche Größe der Kristalle mehr als 5 $\mu$m beträgt, sodass in der Glaskeramik beim Abkühlen Spannungen auftreten und innerhalb der Glaskeramik Mikrorisse resultieren. Zwar werden auf diese Weise Werkstücke erhalten, welche einen niedrigen thermischen Ausdehnungskoeffizienten aufweisen. Dieser liegt zwischen $-3,0 \times 10^{-6}$/K und $-9,0 \times 10^{-6}$/K. Jedoch ist dieser Wert durch die Mikrorisse im Material beeinflusst, sodass ein niedrigerer Wert der thermischen Dehnung bestimmt wird, als das Material intrinsisch eigentlich mitbringt. Dies resultiert in unerwünschten Hystereseeffekten bei Durchlaufen mehrerer Temperaturzyklen, sodass das Material für viele Anwendungen nicht einsetzbar ist.

Weiterhin sind auch Materialien anderer Zusammensetzung bekannt, welche eine niedrige, insbesondere eine negative thermische Dehnung aufweisen. Beispielsweise beschreibt die US-amerikanische Patentschrift US 6,187,700 B1 Materialien mit einem negativen thermischen Ausdehnungskoeffizienten, welche Wolframate umfassen. Die Materialien werden dabei über einen Sinterprozess erhalten, indem Feststoffe miteinander vermischt und anschließend einer Temperaturbehandlung unterzogen werden. Auf diese Weise entsteht ein keramisches Material, welches einen thermischen Ausdehnungskoeffizienten im Bereich zwischen $-5,0 \times 10^{-6}$/K und $-8,8 \times 10^{-6}$/K aufweist und das frei von Mikrorissen ist.

Dokument US 2003/187117 A1 beschreibt ein Verbundmaterial, das sphärische $ZrW_2O_8$-Partikel, die ebenfalls einen negativen thermischen Ausdehnungskoeffizienten aufweisen, und ein Epoxidharz enthält.

Neben den in der genannten Patentschrift offenbarten Wolframaten werden in der wissenschaftlichen Literatur auch Molybdate und Vanadate mit negativem thermischen Ausdehnungsverhalten beschrieben [z. B. C. Lind, Materials 5 (2012) 1125-1154]. Dabei kann deren Herstellung entweder über einen Reaktivsinterprozess aus den Einzeloxidkomponenten, wie beispielsweise für $Y_2Mo_3O_{12}$ bei B.A. Marinkovic et al., Solid State Sciences 7 (2005) 1377-1383 beschrieben, oder über einen (modifizierten) Sol-Gel-Prozess, wie z. B. für W-dotiertes $ZrV_2O_7$ bei Q. Liu et al., Applied Surface Science 313 (2014) 41-47 dargelegt, erfolgen.

Aufgabe der vorliegenden Erfindung ist es, ein Verbundmaterial umfassend wenigstens ein erstes Material und Partikel, bereitzustellen, wobei die Partikel einen negativen thermischen Ausdehnungskoeffizienten $\alpha$ aufweisen. Das Verbundmaterial soll wesentlich höhere Partikelfüllgarde als bislang erreichbar aufweisen. Es soll einfacher und wirtschaftlicher herstellbar sein und sich zum Verkleben von Gegenständen oder als Zusatz zu Klebern eignen.

Gelöst wird die Aufgabe durch ein Verbundmaterial, umfassend wenigstens ein erstes Material und Partikel, wobei

- die Partikel einen negativen thermischen Ausdehnungskoeffizienten $\alpha$ aufweisen,
- die Partikel eine Sphärizität $\Psi$ von wenigstens 0,7 aufweisen, und
- das Verbundmaterial wenigstens 30 Vol.-% der Partikel bei einer Partikelgröße von $d_{50} < 1,0$ $\mu$m enthält, oder
- das Verbundmaterial wenigstens 40 Vol-% der Partikel bei einer Partikelgröße $d_{50} > 1,0$ $\mu$m enthält,
- und die Partikel $ZrW_2O_8$ als Hauptkristallphase aus dem Phasensystem $ZrO_2$-$WO_3$-$Al_2O_3$-$P_2O_5$ umfassen.

Dabei ist die Sphärizität Ψ eine Kenngröße dafür, wie kugelförmig der Partikel ist. Nach der Definition nach H. Wadell berechnet sich die Sphärizität Ψ eines Partikels als das Verhältnis der Oberfläche einer Kugel gleichen Volumens zur Oberfläche des Partikels:

$$\Psi = \frac{\sqrt[3]{36\pi V_p^2}}{A_p}$$

wobei $V_p$ das Volumen des Partikels und $A_p$ seine Oberfläche bezeichnet.

Typische Sphärizitätswerte Ψ für verschiedene Partikeltypen sind:

| | |
|---|---|
| Kugel: | 1,0 |
| Tropfen, Blase, rundes Korn: | 0,7 - 1,0 |
| Eckiges Korn: | 0,45 - 0,6 |
| Nadelförmiges Partikel: | 0,2 - 0,45 |
| Plättchenförmiges Partikel: | 0,06 - 0,16 |
| Partikel mit stark zerklüfteter Oberfläche: | $10^{-8}$ - $10^{-4}$ |

Hohe Sphärizitäten Ψ im Sinne der hier vorliegenden Erfindung werden erreicht, wenn Ψ einen Wert von wenigstens 0,7 aufweist.

Definition d-Wert, insbesondere dso-Wert:

Die Partikel eines Pulvers werden generell unabhängig von ihrer Sphärizität Ψ mit Hilfe eines zu messenden volumenäquivalenten Kugeldurchmessers unterschieden und entsprechend ihrer Größe in ausgewählte Klassen eingeordnet. Zur Darstellung einer Partikelgrößenverteilung werden die Mengenanteile bestimmt, mit denen die jeweiligen Partikelklassen im Pulver vorhanden sind.

Dabei werden unterschiedliche Mengenarten verwendet. Werden die Partikel gezählt, so ist die Mengenart die Anzahl. Bei Wägungen hingegen ist es die Masse bzw. bei homogener Dichte $\rho$ das Volumen. Weitere leiten sich aus Längen, Projektions- und Oberflächen her.

Man unterscheidet:

| Mengenart: | Index r |
|---|---|
| Anzahl | 0 |
| Länge | 1 |
| Fläche | 2 |
| Volumen (Masse) | 3 |

Ein gängiges Mengenmaß zur Beschreibung der Partikelgrößenverteilung in Pulvern bildet die Summenverteilung $Q_r$. Der Index r bezeichnet die Mengenart gemäß obiger Tabelle.

Die Summenverteilungsfunktion Qr(d) gibt die normierte Menge aller Partikel mit einem Äquivalentdurchmesser kleiner gleich d an. Im Folgenden werden Summenverteilungen der beiden gebräuchlichsten Mengenarten explizit definiert:

• Partikelzahl (r = 0)

Sei $N_i$ die Zahl aller untersuchten Partikel mit einem Durchmesser d kleiner oder gleich dem betrachteten Durchmesser $d_i$ sowie N die Gesamtzahl aller untersuchten Partikel. Dann ist

$$Q_0(d_i) = \frac{N_i}{N}$$

• Partikelmasse (r = 3)

Sei $m_i$ die Masse aller untersuchten Partikel mit einem Durchmesser d kleiner oder gleich dem betrachteten Durchmesser $d_i$ sowie m die Gesamtmasse aller untersuchten Partikel. Dann ist

$$Q_3(d_i) = \frac{m_i}{m}$$

Unter di-Werten i. S. der Erfindung werden Äquivalentdurchmesserwerte verstanden, bei denen die $Q_3(d_i)$-Summenverteilungsfunktion die folgenden Werte annimmt:

$d_{10}$:     $Q_3(d_{10}) = 1 0\%$, d. h. 10 Gew.-% der Partikeln weisen einen Durchmesser kleiner als oder gleich $d_{10}$ auf.

$d_{50}$:     $Q_3(d_{50}) = 50\%$, d. h. 50 Gew.-% der Partikeln weisen einen Durchmesser kleiner als oder gleich dso auf.

$d_{90}$:     $Q_3(d_{90}) = 90\%$, d. h. 90 Gew.-% der Partikeln weisen einen Durchmesser kleiner als oder gleich $d_{90}$ auf.

$d_{99}$:     $Q_3(d_{99}) = 99\%$, d. h. 99 Gew.-% der Partikeln weisen einen Durchmesser kleiner als oder gleich $d_{99}$ auf.

$d_{100}$:     $Q_3(d_{100}) = 100\%$, d. h. 100 Gew.-% der Partikeln weisen einen Durchmesser kleiner als oder gleich $d_{100}$ auf.

Überraschenderweise hat sich gezeigt, dass mit Partikeln, die eine Sphärizität $\Psi$ von wenigstens 0,7 aufweisen, ein wesentlicher höherer Partikelfüllgrad erzielt werden kann. So sind erfindungsgemäße Verbundmaterialien zugänglich, die wenigstens 30 Vol.-% der Partikel enthalten, wenn deren Größe einen Wert von $d_{50} \leq 1,0\ \mu$m aufweist, oder wenigstens 40 Vol-% der Partikel, wenn deren Größe einen Wert von $d_{50} > 1,0\ \mu$m annimmt.

In eine besonders bevorzugten Ausführungsform der Erfindung weisen die Partikel eine Sphärizität $\Psi$ von wenigstens 0,8 und besonders bevorzugt von wenigstens 0,9 auf.

In einer weiteren Ausführungsform enthält das Verbundmaterial bevorzugt wenigstens 35 Vol.-% der Partikel und besonders bevorzugt wenigstens 40 Vol.-% der Partikel, wenn die Größe der Partikeln einen Wert von $d_{50} \leq 1,0\ \mu$m aufweist, bzw. bevorzugt wenigstens 45 Vol-% der Partikel und besonders bevorzugt wenigstens 50 Vol-% der Partikel, wenn die Größe der Partikeln einen Wert von $d_{50} > 1\ \mu$m annimmt.

Vorzugsweise ist das erste Material ausgewählt aus der Gruppe der Polymere, insbesondere der Epoxid- oder Acrylatharze, oder aus der Gruppe der Gläser, insbesondere der Glasfritten oder Glaslote oder aus Kombinationen aus diesen Gruppen.

Partikel mit einem negativen thermischen Ausdehnungskoeffizienten können aus der Gruppe der folgenden Verbindungen oder aus Kombinationen aus diesen Gruppen:

-   $ZrW_2O_8$,
-   $Y_2Mo_3O_{12}$,
-   $LiAlSiO_4$,
-   $LiAlSi_2O_6$,
-   Phasensystem $ZrO_2$-$WO_3$-$Al_2O_3$-$P_2O_5$

ausgewählt sein,
wobei die Partikel im erfindungsgemäßen Verbundmaterial $ZrW_2O_8$ als Hauptkristallphase aus dem Phasensystem $ZrO_2$-$WO_3$-$Al_2O_3$-$P_2O_5$ umfassen.

Die Partikel weisen bevorzugt einen negativen thermischen Ausdehnungskoeffizienten $\alpha$ im Bereich von $-1,0 \times 10^{-6}$/K bis $-100 \times 10^{-6}$/K im Temperaturbereich von -50 °C bis 200 °C auf.

Bevorzugt sind die Partikel mittels wenigstens einem der folgenden Verfahren hergestellt:

-   Sprühkalzinierung (im Besonderen unter Verwendung der Pulsationsreaktortechnologie)
-   Filamentierung aus einer Salzschmelze,
-   Vertropfung,
-   Glaskugelherstellung.

Im Hinblick auf den Stand der Technik sind daher pulverförmige, negativ dehnende Partikeln wünschenswert, die eine hohe Sphärizität $\Psi$ aufweisen. Beispielhaft sollen an dieser Stelle folgende Verfahren angeführt werden:
Glaskugelherstellung: Der Weg, Partikeln aus einem negativ dehnendem Material herzustellen, nutzt den Umstand, dass solche Materialien u. a. auch über die Glaskeramikroute darstellbar sind: Hierzu wird in einem gängigen Schmelzverfahren zunächst ein im Idealfall kristallfreies Grünglas geschmolzen, das im Zuge eines nachgeschalteten Temperschritts keramisiert und dabei in die eigentliche Glaskeramik überführt wird. Das im ersten Prozessschritt hergestellte Glasschmelze kann beim Abkühlen prinzipiell den üblichen für die Herstellung von Glaskugeln angewandten Heißformgebungsprozessen unterworfen werden. Hierfür sind folgende Verfahrensansätze denkbar: In dem in US 3,499,745 offenbarten Verfahren, wird ein geschmolzener Glasstrahl auf ein Schlagrad aufprallen lassen, welches bei Realisierung hinreichend großer Kräfte den Glasstrahl dazu bringt, in Teilstränge, sog. Filamente, aufzubrechen. Diese werden anschließend zunächst durch einen beheizten Bereich, eine Kühlregion und schließlich in eine Sammelzone geschleudert. Infolge der nach der Filamentbildung wirksam werdenden Tendenz zur Minimierung der Oberflächenspannung verrunden diese. Gemäß der EP 1 135 343 B1 wird dabei eine hinreichende Sphärizität erzielt, wenn eine Relaxationszeit ab dem Zeitpunkt der Filamentbildung verstrichen ist, die durch die Gleichung $T = (d \times \mu) / \sigma$ beschrieben werden kann. Dabei handelt es sich bei d um den Durchmesser der gebildeten Kugeln, $\mu$ die Viskosität des Filaments und $\sigma$ die Oberflächenspannung des Filaments während der Relaxationszeit. Wie in der US 3,495,961 beschrieben, kann anstelle des Schlagrads auch ein Rotor verwendet werden. Andere bekannte Verfahren zur Herstellung von Glaskugeln umfassen das Aufblasen eines brennenden Gasstroms quer durch einen geschmolzenen Glasstrahl, um das Glas in einzelne Teilchen zu zerteilen.

Derartige Verfahren sind in der US 3,279,905 offenbart. Alternativ dazu können Glaspartikeln niedrigerer Sphärizität, wie in der DD 282 675 A5 beschrieben, durch Einbringen in eine Flamme (teilweise) wieder aufgeschmolzen werden und dabei verrunden.

Filamentierung von Salzschmelzen: Analog zur oben beschriebenen Filamentbildung und der anschließenden, infolge von Relaxationseffekten zur Verringerung der Oberflächenenergie auftretenden Bildung von sphärischen Tropfen aus einem aufgeschmolzenen Glasstrahl kann diese entsprechend aus einem aus einer Salzschmelze erzeugten Materialstrahl erfolgen. Technologisch kann hierzu in ähnlicher Weise verfahren werden, wobei zu beachten ist, dass sich die Viskosität eines aufgeschmolzenen Glases sich von derjenigen einer Salzschmelze je nach der im jeweiligen Fall gewählten Temperatur deutlich voneinander unterscheiden kann. Das tropfenförmige Material muss durch Durchleiten durch einen noch heißeren Bereich zunächst in eine präkeramische, häufig poröse, aber abgesehen von einem isotropen Schrumpf formstabile Zwischenstufe überführt und anschließend weiter - entweder noch im selben oder in einem gesonderten zusätzlichen, nachgeschalteten Temperschritt - in das eigentliche negativ dehnende Material überführt werden. Idealerweise werden so dicht gesinterte Kugeln aus dem negativ dehnenden Material erhalten.

Sprühkalzinierunq (unter Verwendung der Pulsationsreaktortechnologie): Bei Verwendung eines Pulsationsreaktors, wie in der DE 10111938 A1, DE 102006027133 A1, DE 102006039462 A1 oder EP 1927394 A1 offenbart, wird eine gasförmige oder eine flüssige Mischung in Form einer Lösung, Suspension oder Dispersion, die alle Komponenten zur Herstellung des negativ dehnenden Materials enthält, in einen pulsierenden Heißgasstrom eingebracht - in letzterem Fall durch feines Zerstäuben. Dabei wird der pulsierende Heißgasstrom selbst innerhalb eines Heißgaserzeugers am Reaktor durch die Verbrennung von Erdgas oder Wasserstoff mit Umgebungsluft erzeugt. Je nach Wahl der Lage des Einsprühpunktes herrschen dort Temperaturen zwischen 500 und 1500 °C. Im pulsierenden Heißgasstrom wird ein Zwischenprodukt gebildet, das durch weitere thermische Nachbehandlung im gleichen oder in einem anderen Reaktor in die endgültige Form überführt. In ersterem Fall kann der Reaktor mit einer zusätzlichen Brennstoffzufuhr versehen werden, die entlang des pulsierenden Heißgasstroms dem Einsprühpunkt nachgelagert ist.

Vertropfungsverfahren: Beim Vertropfungsverfahren wird von einer wässrigen oder lösemittelbasierten Salzlösung oder einem Sol als Vorstufe für das negativ dehnende Material bzw. einer nanopartikulären Lösung des negativ dehnenden Materials ausgegangen und über eine geeignete Düsenvorrichtung in Tropfen überführt. Die Tropfen werden nach ihrer Bildung wahlweise direkt in einem geeigneten Prozessgasstrom getrocknet, wie in der US 4043507 oder US 5500162 beschrieben, oder durch Einbringen in ein geeignetes flüssiges Medium, wie in der US 5484559, US 6197073, US 2004/0007789 A1 oder WO 2015/014930 A1 offenbart, zunächst zu weiterer Flokkulation angeregt und anschließend gealtert, gewaschen und getrocknet. Die auf diese Weise dargestellten sphärischen, porösen Grünkörper werden in einem anschließenden Sinterschritt zu einem negativ dehnenden Keramikkörper mit hoher Sphärizität verdichtet.

Es werden Formulierungen zur Herstellung von Verbundmaterialien (polymerbasierten Komposite bzw. Kompositvorstufe), z. B. für die Verwendung als Klebematerialien, angegeben, in denen bei gleichen Volumenfüllgraden die Viskosität der partikelgefüllten Formulierung im Fall der Verwendung von nicht-sphärischen Partikeln signifikant höher ist als bei der Verwendung der erfindungsgemäß hergestellten, Partikeln hoher Sphärizität, vorausgesetzt Partikelgröße bzw. Partikelgrößenverteilung sind in beiden Fällen gleich.

Weiterhin werden Formulierungen zur Herstellung von Verbundmaterialien (polymerbasierte Komposite oder Kompositvorstufen), z. B. für die Verwendung als Klebematerialien, bereitgestellt, in denen sich die entsprechenden Formulierungen ohne wesentliche Änderung der Viskosität im Fall der sphärischen Variante mit deutlich höheren Füllgraden versehen lassen als im Fall der nicht-sphärischen Ausführungsform. Vorausgesetzt ist auch in diesem Fall wieder, dass sich Partikelgröße und Partikelgrößenverteilung in beiden Fällen nicht wesentlich unterscheiden.

Gelöst wird die Aufgabe auch durch ein Klebematerial umfassend das erfindungsgemäße Verbundmaterial, insbesondere zum Verkleben von Verpackungen für Halbleiter.

Allen bisher im Stand der Technik zur Herstellung der negativ dehnenden Materialien beschriebenen Verfahren ist gemein, dass das im jeweiligen Prozess erzeugte Rohmaterial entweder monolithisch oder doch zumindest in undefiniert grobkörniger Struktur anfällt und durch weitere Zerkleinerungsschritte, in der Regel Feinmahlprozesse, in eine endgültige Darreichungsform als Pulver mit definierter Partikelgröße und Partikelgrößenverteilung gebracht werden muss. Häufig liegt die zu erreichende Partikelgröße im $\mu$m- oder sub-$\mu$m-Bereich. Erst hierdurch wird eine weitere Prozessierung möglich. Hierbei ist im Besonderen die Einarbeitung in organische Massen, beispielsweise Polymere oder deren Harzvorstufen zu nennen, welche als Klebstoff eingesetzt werden können. Organische Verbindungen, insbesondere Polymere, weisen in der Regel eine sehr hohe Wärmedehnung auf. Sollen solche Polymere zur Verklebung eingesetzt werden, beispielsweise zur Verklebung von anorganischen Materialien, beispielsweise im optischen Bereich oder in der Chip-Industrie, kann es hierbei zu Schwierigkeiten, wenn der Klebeverbund größeren thermischen Schwankungen ausgesetzt ist. Aufgrund der sehr stark unterschiedlichen Ausdehnungskoeffizienten des Polymers und der zu verklebenden, anorganisch ausgebildeten Materialien werden zwischen den zu verbindenden Materialien thermomechanische Spannungen induziert, welche im schlimmsten Falle sogar zu einem mechanischen Versagen des geklebten Bauteils führen können. Solche Versagensfälle können vermieden oder zumindest deutlich reduziert werden, wenn der integrale thermische Ausdehnungskoeffizient, also der für das gesamte Klebematerial resultierende Ausdehnungskoeffizient, reduziert wird. Dies wird auf einfache Weise durch den Zusatz von anorganischen Füllstoffen mit niedriger thermischer Dehnung bewirkt. Bekannte Füllstoffe, welche heute zu diesem Zweck eingesetzt werden, umfassen $SiO_2$, sowohl in kristalliner Form als auch amorph als sogenannte Kieselsäure bzw. als Quarzglaspartikel. Die $SiO_2$-basierten Materialien weisen dabei einen betragsmäßig zwar sehr geringen, jedoch positiven thermischen Ausdehnungskoeffizienten auf, dessen Wert in der Größenordnung von etwa $+1 \times 10^{-6}$/K liegt.

Über Zerkleinerungsprozesse, wie z. B. besagte Feinmahlprozesse, wie sie wie eben erwähnt zur Darstellung der negativ dehnenden Pulvermaterialien mit einer Partikelgröße im mikro- oder sub-mikroskaligen Bereich notwendig sind, ist die Darstellung sphärischer Pulverpartikeln praktisch nicht möglich. Vielmehr werden hierbei scherbenförmige, mit Ecken und Kanten versehene Partikeln gebildet. Diese weisen demnach eine Sphärizität von deutlich kleiner als 0,7 auf.

Nicht-sphärische Partikeln ein und desselben Materials lassen sich in vielen Anwendungen deutlich schlechter verarbeiten als ihre sphärischen Pendants - gleiche Partikelgröße und Partikelgrößenverteilung vorausgesetzt. Insbesondere bei der Einarbeitung in thermoplastische und flüssige Matrizes (wie bei flüssigen Harzvorstufen für duroplastische Kleber der Fall) macht sich dieser Umstand bemerkbar: Bei gleichen Volumenfüllgraden ist die Viskosität der partikelgefüllten Formulierung im Fall der Verwendung von nicht-sphärischen Partikeln signifikant höher als bei der Verwendung von sphärischen Partikeln aus dem gleichen Material, wenn diese eine vergleichbare Partikelgröße bzw. Partikelgrößenverteilung besitzen. Umgekehrt lassen sich entsprechende Formulierungen im Fall der sphärischen Variante mit deutlich höheren Füllgraden versehen als im Fall der nicht-sphärischen Ausführungsform. Dies ist auf den Umstand zurückzuführen, dass die innere Reibung in mit nicht-sphärischen Partikeln gefüllten Formulierungen dadurch erhöht ist, dass die Partikeln zum gegenseitigen Verhaken neigen, wenn sie sich infolge der Einwirkung von äußeren Scherkräften innerhalb der Formulierung aneinander vorbei bewegen. Im Fall sphärischer Partikeln vermögen diese hingegen besser aneinander vorbei zu gleiten.

Der Umstand, dass sich bei Verwendung von sphärischen Partikeln in hiermit gefüllten Formulierungen unter vergleichbaren Bedingungen deutlich höhere Volumenfüllgrade erzielen lassen, ist in der Praxis von großer Relevanz: So lassen sich beispielsweise einerseits für Klebematerialien, die als Vergussmassen (Molds, Encapsulants) dienen sollen, final nach dem Aushärten Komposite mit minimierten thermischen Ausdehnungskoeffizienten realisieren, ohne dass die Verarbeitbarkeit der flüssigen Klebstoffvorstufen vor dem Aushärten durch das Einbringen des Füllstoffs verloren geht. Andererseits sind Füllstoffe in Klebematerialien, die zum Unterfüllen beim Fügen von Halbleiterbauteilen zur Anwendung kommen (Underfills), in ihrer maximalen Partikelgröße beschränkt. Die Grenze kann infolge des fortschreitenden Trends zur Minimalisierung hier deutlich im submikroskaligen Bereich liegen. Aufgrund der mit kleiner werdender Partikelgröße immer stärker wirksam werdender Partikel-Partikel-Wechselwirkungen steigt die Viskosität der Vorstufen von entsprechenden Kompositen schon bei geringeren Füllgraden häufig stark an. Schnell ist hier eine Grenze erreicht, bei der die Verarbeitbarkeit der Vorstufe nicht mehr gewährleistet ist. Durch den Einsatz von sphärischen Füllstoffpartikeln lässt sich der maximal erreichbare Füllgrad gegenüber demjenigen Wert, wie er im Fall der Verwendung von nicht-sphärischen Partikeln erzielbar ist, nochmals deutlich steigern. In diesen Fällen ist die Verarbeitbarkeit der Klebervorstufe auch bei höheren Füllgraden immer noch gegeben. Gleichzeitig ist der thermische Ausdehnungskoeffizient des Klebematerials nach Aushärten wunschgemäß signifikant reduziert.

Die Partikel mit negativer thermischer Ausdehnung sind für die Klebstoffindustrie von großer Bedeutung: durch die Zugabe als Füllstoffes zu einem Polymer/ Mehrkomponentenklebstoff kann dessen eigene thermische Ausdehnung stark minimiert und somit eine Diskrepanz zwischen dem unterschiedlichen Dehnungsverhalten der zu verbindenden Materialien reduziert werden. Mechanische Spannungen zwischen den zu verbindenden Komponenten werden dadurch erheblich reduziert und die Lebensdauer des gesamten Bauteils signifikant verlängert bzw. überhaupt erst in einem für die Anwendung erheblichem Maße ermöglicht, insbesondere bei der Verklebung in der Chip-Technologie (Molding, Potting, Underfill), aber auch bei anderen klebetechnischen Fragestellungen (z.B. Automobil, Linsenaufbau bei Kameras).

Ausführungsbeispiele

Beispiele zur Herstellung von Partikeln mit einem negativen thermischen Ausdehnungskoeffizienten $\alpha$ und einer Sphärizität $\Psi$ von wenigstens 0,7:

1. Herstellung von sphärischen Partikeln mit $ZrW_2O_8$ als Hauptkristallphase einer Glaskeramik aus dem Phasensystem $ZrO_2$-$WO_3$-$Al_2O_3$-$P_2O_5$-

(A) Formgebung direkt aus der Grünglasschmelze

Ein Ausgangsglas für eine final negativ dehnende Glaskeramik der Zusammensetzung 24,2 Gew.-% ZrO2, 68,6 Gew.-% $WO_3$, 1,4 Gew.-% $Al_2O_3$ und 5,8 Gew.-% $P_2O_5$ wurde in einem Ablauftiegel bei einer Temperatur von 1650 °C erschmolzen.

Die Glasschmelze wurde im gewählten Schmelzaggregat auf einer Temperatur von 1550 °C gehalten. Über eine am Boden des Tiegels angebrachte Düse von einem Durchmesser von 1 mm wurde es ablaufen lassen. Der so erzeugte Glasstrahl wurde auf ein 53-zähniges, 8 mm dickes Schlagrad mit einem Außendurchmesser von 135 mm tropfen lassen, das sich mit einer Frequenz von 5000 U/min um die eigene Achse drehte. Auf diese Weise wurde der Glasstrom in einzelne Stücke filamentiert und mit einem Neigungswinkel zwischen 20 bis 30° gemessen gegen die Horizontale beschleunigt. Anschließend wurde er durch einen 3 m langen, mit zwei Gasbrennern auf 1550 °C beheizten, kurvenförmig gebauten Rohr-ofen geleitet, der die Flugbahn des filamentierten Glasstroms nachzeichnete. Infolge der Neigung zur Minimierung der Oberflächenenergie formten sich die länglich geformten Filamente zu Kugeln um. Nach Austritt aus dem Rohr-Ofen wurden die Glaskugeln durch weiteren Flug an Luft bis zum Erreichen einer ausreichenden Formstabilität abkühlen lassen und schließlich in einem Sammelbehälter aufgefangen.

Die nach dem beschriebenen Heißformgebungsprozess hergestellten, abgekühlten, weitestgehend röntgenamorphen Grünglaskugeln wurden im Zuge einer weiteren Temperaturbehandlung bei einer Maximaltemperatur von 650 °C und Haltezeit von 12 bis 24 Stunden keramisiert und somit in die finale, negativ dehnende Glaskeramik überführt.

(B) Formgebung durch Verrundung von nicht-sphärischen Grünglaspartikeln

Ein Ausgangsglas für eine final negativ dehnende Glaskeramik der Zusammensetzung 24,2 Gew.-% $ZrO_2$, 68,6 Gew.-% $WO_3$, 1,4 Gew.-% $Al_2O_3$ und 5,8 Gew.-% $P_2O_5$ wurde in einem Ablauftiegel bei einer Temperatur von 1650 °C erschmolzen.

Die Glasschmelze wurde im gewählten Schmelzaggregat auf einer Temperatur von 1550 °C gehalten. Über eine am Boden des Tiegels angebrachte Düse von einem Durchmesser von 1 mm wurde es ablaufen in einen Spalt zwischen zwei sich gegeneinander drehenden, wassergekühlten Walzen laufen lassen und dabei unter Bildung eines Grünglasbandes abgeschreckt. Das Grünglasband wurde mechanisch mit einem Hammer in kleine Splitter vereinzelt.

Die Glassplitter wurden durch Vormahlung in einer Kugelmühle grobzerkleinert und hiervon die Pulverfraktion mit einer Partikelgröße $d_{100}$ < 100 $\mu$m abgesiebt. Dieses abgesiebte Grünglaspulver wurde in einem weiteren nachgeschalteten Schritt in einer Trockenmahlung auf einer Gegenstrahlmühle auf eine Partikelgröße mit einer Verteilung von $d_{10}$ = 0,8 $\mu$m, $d_{50}$ = 5,2 $\mu$m, $d_{90}$ = 12,4 $\mu$m und $d_{99}$ = 18,8 $\mu$m weiter zerkleinert.

Durch Einbringen des Pulvers in eine Erdgasflamme werden die Glaspartikeln wieder aufgeschmolzen und erfahren dabei infolge der Tendenz zur Minimierung der Oberflächenenergie eine Verrundung. Nach Austritt aus der Flamme werden die Partikeln abkühlen lassen und in einem Sammelbehälter aufgefangen.

Die nach dem beschriebenen Heißformgebungsprozess hergestellten, abgekühlten, weitestgehend röntgenamorphen Grünglaskugeln wurden im Zuge einer weiteren Temperaturbehandlung bei einer Maximaltemperatur von 650 °C und Haltezeit von 12 bis 24 Stunden keramisiert und somit in die finale, negativ dehnende Glaskeramik überführt.

2. Filamentierung von Salzschmelzen zur Herstellung von sphärischen $Y_2Mo_3O_{12}$-Partikeln (nicht erfindungsgemäß)

964 g Yttriumacetat-tetrahydrat und 754 g Ammoniummolybat-tetrahydrat wurden in eine Kugelmühle gegeben und dort zur Herstellung einer möglichst homogenen Pulvermischung für 4 h gemahlen. Als Mahlkugeln wurden hierzu $Al_2O_3$-Kugeln mit einem Durchmesser von 40 mm verwendet.

Nach dem Absieben wurde die Pulvermischung in einen Platinablauftiegel gegeben und dort vorsichtig auf eine Temperatur von 100 °C gebracht, knapp oberhalb des Schmelzpunkts von Ammoniummolybdat-tetrahydrat, der bei 90 °C liegt. Dabei bildet sich eine Salzschmelze aus, die über eine am Boden des Tiegels angebrachte Düse von einem Durchmesser von 2 mm wurde ablaufen lassen wurde. Der so erzeugte aus der Salzschmelze bestehende Strahl wurde auf ein 53-zähniges, 8 mm dickes Schlagrad mit einem Außendurchmesser von 135 mm tropfen lassen, das sich mit einer Frequenz von 5000 U/min um die eigene Achse drehte. Auf diese Weise wurde der aus der Salzschmelze bestehende Strahl in einzelne Stücke filamentiert und mit einem Neigungswinkel zwischen 20 bis 30° gemessen gegen die Horizontale beschleunigt. Anschließend wurde er durch einen 3 m langen, kurvenförmig gebauten Rohrofen geleitet, der die Flugbahn des filamentierten aus der Salzschmelze bestehenden Strahls nachzeichnete. Der Ofen wurde dergestalt elektrisch beheizt, dass er in der Eintrittszone auf moderaten Temperaturen von 100 -

120 °C gehalten wurde, so dass die Salzschmelze weiter erhalten blieb und sich die zunächst noch länglich geformten Filamente infolge der Neigung zur Minimierung der Oberflächenenergie zu noch flüssigen Kugeln umformten. In den nachgeschalteten Zonen wurde die Temperatur dann deutlich höher gewählt - Temperaturen von rund 900 °C wurden hier erreicht. Infolgedessen trat hier ein erster Schritt zur Calcinierung der flüssigen Kugeln ein, wobei sich poröse, präkeramische Partikeln als Zwischenstufe ausbildeten. Nach Austritt aus dem Rohrofen wurden diese durch weiteren Flug an Luft abkühlen lassen und schließlich in einem Sammelbehälter aufgefangen.

Die porösen, präkeramischen Partikeln wurden einem weiteren Calcinierungsschritt in einem Ofen bei 900 °C und einer Haltezeit von 7 - 8 h zu den finalen, aus negativ dehnenden $Y_2Mo_3O_{12}$-Material bestehenden Kugeln verdichtet.

3. Herstellung von sphärischen $ZrW_2O_8$-Partikeln über die Sprühkalzinierung unter Verwendung der Pulsationsreaktormethode (nicht erfindungsgemäß)

584,5 g (2,0 mol) Ethylendiamintetraessigsäure (EDTA) wurden in 6,0 L (333 mol) Wasser suspendiert. Parallel dazu wurden 560 g (4,0 mol) 25%ige wässrige Ammoniumhydroxidlösung in 3,6 L (200 mol) Wasser gegeben. Die Ammoniumhydroxidlösung wurde anschließend unter Rühren zur EDTA-Lösung zugetropft. Anschließend wurden zu dieser teilneutralisierten EDTA-Lösung 644,5 g (2,0 mol) Zirkoniumoxidichlorid-octahydrat $ZrOCl_2 \times 8\,H_2O$ zugegeben. Infolgedessen fiel ein dicker, weißer Niederschlag aus, der sich bei Erhitzen der Lösung auf 100 °C wieder auflöste. Die Lösung wurde bei dieser Temperatur für 1 h rühren und anschließend über Nacht abkühlen lassen. In der Folge entstand durch teilweises Ausfällen der farblosen Kristalle eines Zr-EDTA-Komplexes eine trübe Lösung, die am Rotationsverdampfer bis zur Trockene eingeengt wurde. Anschließend wurde der feste Rückstand des Gemischs aus Zr-EDTA-Komplex und $NH_4Cl$ (Gewichtsverhältnis: 78% : 22%) für 24 h bei 110 °C getrocknet.

292,2 g (1,0 mol) Ethylendiamintetraessigsäure wurden in 5,0 L (278 mol) Wasser gelöst und anschließend mit 300 ml (2,0 mol) 25%iger wässriger Ammoniumhydroxidlösung versetzt. Darin wurden 463,7 g (1,7 mol $WO_3$-Äquivalent) Ammoniummetawolframat-hydrat $(NH_4)_6H_2W_{12}O_{40} \times n\,H_2O$ (85 Gew.-% $WO_3$) gelöst. Anschließend wurden 487,1 g des Zr-EDTA-Komplex/$NH_4Cl$-Gemischs (i. e. 1,0 mol Zr-EDTA-Komplex) zugegeben und unter mildem Erwärmen darin gelöst.

Die Lösung wird mit Hilfe einer Schlauchpumpe in einen Pulsationsreaktor mit einem Volumenstrom von 3 kg/h gefördert und dort über eine 1,8 mm Titandüse in das Reaktorinnere fein zerstäubt und dort thermisch behandelt. Die Temperatur der Brennkammer wird dabei auf 1300 °C, diejenige des Resonanzrohrs auf 1200 °C gehalten. Das Verhältnis der Verbrennungsluftmenge zur Brennstoffmenge (Erdgas) betrug 10 : 1 (Luft: Gas).

Das Pulver wird in einen quaderförmigen Korundtiegel gefüllt und in einen Kammerofen gestellt. Das Glühgut wird im Ofen in Luftatmosphäre zur vollständigen Verdichtung der aus $ZrW_2O_8$ bestehenden, sphärischen mikroskaligen Partikeln auf eine Temperatur von 1200 °C gebracht und nach der Temperatur durch Einbringen in einen kalten Luftstrom schlagartig gequencht, so dass das bei Raumtemperatur metastabile Mischoxid keine Gelegenheit bekam, wieder in die Einzelkomponenten zu zerfallen.

4. Herstellung von sphärischen $ZrW_2O_8$-Partikeln über das Vertropfungsverfahren (nicht erfindungsgemäß)

58,5 g (0,2 mol) Zirkoniumoxichlorid-octahydrat $ZrOCl_2 \times 8\,H_2O$ wurden zu 500 mL (27,8 mol) Wasser gegeben und darin gelöst. Zur Mischung wurden zusätzlich 252,2 g (1,2 mol) Citronensäure-Monohydrat gegeben und gelöst. Die Verbindung fungierte als Komplexbildner zur Stabilisierung der $Zr^{4+}$-Ionen, um deren frühzeitiges Ausfällen im Zuge der weiteren Prozessierung zu verhindern. Parallel wurde eine separate Lösung von 90 g (0,33 mol $WO_3$-Äquivalent) Ammoniummetawolframat $(NH_4)_6H_2W_{12}O_{40} \cdot \times H_2O$ (85% $WO_3$) in 500 mL Wasser angesetzt. Anschließend wurden beide Lösungen vereinigt.

Aus der so hergestellten Stammlösung wurden mittels eines Vertropfungsverfahrens über Düsen und/oder Kanülen formstabil Gelkörper der Größen 0,3 bis 2,5 mm durch Eintauchen sowie Reaktion in einer Ammoniaklösung bei einer Temperatur von 60 °C erhalten.

Diese Gelkörper wurden im Anschluss durch Calcinierung bei zu gesinterten Kugeln durch ein Sinterverfahren geformt. Die Sinterung erfolgte an Luftatmosphäre unter Normaldruck. Zunächst wurde in einem ersten Schritt auf 700 - 800 °C erhitzt und dort für 12 h gehalten, um die organischen Bestandteile aus dem Gel rückstandsfrei auszubrennen. Anschließend wurde die Temperatur auf 1180 °C erhöht und dort für weitere 2 h zur Realisierung der eigentlichen Reaktivsinterung gehalten. Um einen Zerfall des bei Raumtemperatur metastabilen $ZrW_2O_8$ in die Einzeloxide zu vermeiden, wurden die gebildeten keramischen $ZrW_2O_8$-Sphären zum Abkühlen in einen kalten Luftstrom gegeben.

Beispiele zur Herstellung von erfindungsgemäßen Verbundmaterialien (Herstellung von von Formulierungen gefüllt mit mikro- und sub-mikroskaligen Partikeln hoher Sphärizität aus einem negativ dehnenden Material):

1. Herstellung einer mit mikroskaligen, negativ dehnenden Füllstoffpartikeln gefüllten Epoxidharzvorstufe für die Anwendung als Mold/Encapsulant-Klebematerial in Verpackungsanwendungen im Halbleiterbereich (IC-Packaging)

Zu 10,0 g eines Bisphenol-A-diglycidylether-basierten Epoxidharzes (Dichte: 1,16 g/cm$^3$) mit einer Nullscherratenviskosität von 0,6 Pa s wurden 69,4 g Glaskeramikpulver mit $ZrW_2O_8$ als Hauptkristallphase einer Glaskeramik aus dem Phasensystem $ZrO_2$-$WO_3$-$Al_2O_3$-$P_2O_5$ (thermischer Ausdehnungskoeffizient im Temperaturbereich zwischen 75 und 125 °C: -2,2 ppm/K; Dichte: 5,37 g/cm$^3$) gegeben, das eine Partikelgrößenverteilung von $d_{10}$ = 1,27 $\mu$m, $d_{50}$ = 8,56 $\mu$m, $d_{90}$ = 17,33 $\mu$m und $d_{99}$ = 26,14 $\mu$m aufwies. Dessen Partikeln besaßen eine Sphärizität von im Mittel $\Psi$= 0,93. Zur hinreichenden Dispergierung des Füllstoffpulvers wurde die Mischung für 1 h auf einem Taumler homogenisiert. Die resultierende Klebervorstufe wies einen Volumenfüllgrad von 60 Vol.-% und scherverdünnendes Fließverhalten auf, wobei die Nullscherratenviskosität 114 Pa s betrug. Sie war somit im Blick auf die adressierte Anwendung als Mold/Encapsulant-Klebematerial in Verpackungsanwendungen im Halbleiterbereich (IC-Packaging) noch verarbeitbar.

Es wurde versucht, nach derselben Prozedur eine Klebervorstufe mit einem aus nicht-sphärischen Partikeln ($\Psi$= 0,58) bestehenden Glaskeramikpulvers mit $ZrW_2O_8$ als Hauptkristallphase einer Glaskeramik aus dem Phasensystem $ZrO_2$-$WO_3$-$Al_2O_3$-$P_2O_5$ herzustellen, das eine Partikelgrößenverteilung mit folgenden Werten aufwies: $d_{10}$ = 1,08 $\mu$m, $d_{50}$ = 7,78 $\mu$m, $d_{90}$ = 15,26 $\mu$m $d_{99}$ = 21,06 $\mu$m. In diesen Fällen wurde allerdings nur noch eine knetartige Masse erhalten, die mit in Blick auf die Zielanwendung üblicherweise eingesetzten Dosierapparaturen und -verfahren nicht mehr gehandhabt werden konnte.

2. Herstellung einer mit sub-mikroskaligen, negativ dehnenden Füllstoffpartikeln gefüllten Epoxidharzvorstufe für die Anwendung als Underfill-Klebematerial in Verpackungsanwendungen im Halbleiterbereich (IC-Packaging)

Zu 20,0 g eines Bisphenol-A-diglycidylether-basierten Epoxidharzes (Dichte: 1,16 g/cm$^3$) mit einer Nullscherratenviskosität von 0,6 Pa s wurden 43,5 g Glaskeramikpulver mit $ZrW_2O_8$ als Hauptkristallphase einer Glaskeramik aus dem Phasensystem $ZrO_2$-$WO_3$-$Al_2O_3$-$P_2O_5$ (thermischer Ausdehnungskoeffizient im Temperaturbereich zwischen 75 und 125 °C: -2,2 ppm/K; Dichte: 5,37 g/cm$^3$) gegeben, das eine Partikelgrößenverteilung von $d_{10}$ = 0,18 $\mu$m, $d_{50}$ = 0,56 $\mu$m, $d_{90}$ = 1,17 $\mu$m und $d_{99}$ = 1,82 $\mu$m aufwies. Dessen Partikeln besaßen eine Sphärizität von $\Psi$= 0,91. Zur hinreichenden Dispergierung des Füllstoffpulvers wurde die Mischung für 1 h auf einem Taumler homogenisiert. Die resultierende Klebervorstufe wies einen Volumenfüllgrad von 32 Vol.-% und ein Newtonsches Fließverhalten auf, wobei die Viskosität 13 Pa s betrug. Sie war somit im Blick auf die adressierte Anwendung als Underfill-Klebematerial in Verpackungsanwendungen im Halbleiterbereich (IC-Packaging) noch verarbeitbar.

Es wurde versucht, nach derselben Prozedur eine Klebervorstufe mit einem aus nicht-sphärischen Partikeln ($\Psi$= 0,58) bestehenden Glaskeramikpulvers mit $ZrW_2O_8$ als Hauptkristallphase einer Glaskeramik aus dem Phasensystem $ZrO_2$-$WO_3$-$Al_2O_3$-$P_2O_5$ herzustellen, das eine Partikelgrößenverteilung mit folgenden Werten aufwies: $d_{10}$ = 0,09 $\mu$m, $d_{50}$ = 0,36 $\mu$m, $d_{90}$ = 0,91 $\mu$m $d_{99}$ = 1,55 $\mu$m. In diesen Fällen wurde eine Klebervorstufe mit einer Nullscherratenviskosität von 85 Pa s erhalten, die mit in Blick auf die Zielanwendung üblicherweise eingesetzten Dosierapparaturen und -verfahren nur noch sehr schwer zu handhaben war.

## Patentansprüche

1. Verbundmaterial, umfassend wenigstens ein erstes Material und Partikel, wobei die Partikel einen negativen thermischen Ausdehnungskoeffizienten $\alpha$ aufweisen, wobei die Partikel eine Sphärizität $\Psi$ von wenigstens 0,7 aufweisen und das Verbundmaterial wenigstens 30 Vol.-% der Partikel bei einer Partikelgröße von $d_{50} \leq 1,0$ $\mu$m enthält, oder

   dass das Verbundmaterial wenigstens 40 Vol.-% der Partikel bei einer Partikelgröße $d_{50}$ > 1,0 $\mu$m enthält,
   **dadurch gekennzeichnet, dass**
   die Partikel

      - $ZrW_2O_8$ als Hauptkristallphase

   aus dem Phasensystem $ZrO_2$-$WO_3$-$Al_2O_3$-$P_2O_5$ umfassen.

2. Verbundmaterial nach Anspruch 1,
   **dadurch gekennzeichnet, dass**

das erste Material ausgewählt ist aus der Gruppe der Polymere, insbesondere der Epoxidharze, oder aus der Gruppe der Gläser, insbesondere der Glasfritten oder Glaslote oder aus Kombinationen aus diesen Gruppen.

3. Verbundmaterial nach einem der vorhergehenden Ansprüche,
   **dadurch gekennzeichnet, dass**
   die Partikel einen negativen thermischen Ausdehnungskoeffizienten $\alpha$ im Bereich von -1,0 $\times$ 10$^{-6}$/K bis -100 $\times$ 10$^{-6}$/K im Temperaturbereich von -50 °C bis 200 °C aufweisen.

4. Klebematerial umfassend das Verbundmaterial nach einem der vorhergehende Ansprüche, insbesondere zum Verkleben von Verpackungen für Halbleiter.

## Claims

1. Composite material, comprising at least a first material and particles, wherein the particles have a negative coefficient of thermal expansion a, wherein the particles have a sphericity $\psi$ of at least 0.7 and the composite material contains at least 30 vol% of the particles at a particle size of $d_{50} \leq 1.0$ $\mu$m, or that the composite material contains at least 40 vol% of the particles at a particle size d50 > 1.0 $\mu$m, **characterized in that** the particles comprise

   - $ZrW_2O_8$ as the main crystal phase

   from the phase system $ZrO_2$-$WO_3$-$Al_2O_3$-$P_2O_5$.

2. Composite material according to claim 1, **characterized in that** the first material is selected from the group of polymers, in particular epoxy resins, or from the group of glasses, in particular glass frits or glass solders, or from combinations of these groups.

3. Composite material according to one of the preceding claims, **characterized in that** the particles have a negative coefficient of thermal expansion $\alpha$ in the range from -1.0$\times$10$^{-6}$/K to -100$\times$10$^{-6}$/K in the temperature range from -50°C to 200°C.

4. Adhesive material comprising the composite material according to one of the preceding claims, in particular for bonding packaging for semiconductors.

## Revendications

1. Matériau composite contenant au moins un premier matériau et des particules, lesquelles particules ont un coefficient de dilatation thermique $\alpha$ négatif, lesquelles particules ont une sphéricité $\Psi$ d'au moins 0,7, le matériau composite contenant au moins 30 % en volume de particules d'une taille $d_{50} \leq 1,0$ $\mu$m, ou

   le matériau composite contenant au moins 40 % en volume de particules d'une taille $d_{50}$ > 1,0 $\mu$m,
   **caractérisé en ce que** les particules contiennent du $ZrW_2O_8$ comme phase cristalline principale du système de phases $ZrO_2$-$WO_3$-$Al_2O_3$-$P_2O_5$.

2. Matériau composite selon la revendication 1, **caractérisé en ce que** le premier matériau est choisi dans le groupe des polymères, en particulier des résines époxy, ou le groupe des verres, en particulier des frittes de verre ou des verres pour soudure, ou dans des combinaisons de ces groupes.

3. Matériau composite selon l'une des revendications précédentes, **caractérisé en ce que** les particules ont un coefficient de dilatation thermique $\alpha$ négatif compris entre -1,0 $\times$ 10$^{-6}$/K et -100 $\times$ 10$^{-6}$/K dans la plage de températures de -50 °C à 200 °C.

4. Matériau adhésif contenant le matériau composite selon l'une des revendications précédentes, destiné en particulier au collage d'emballages pour des semi-conducteurs.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6506699 B1
- US 6209352 B1
- US 6187700 B1
- US 2003187117 A1
- US 3499745 A
- EP 1135343 B1
- US 3495961 A
- US 3279905 A
- DD 282675 A5
- DE 10111938 A1
- DE 102006027133 A1
- DE 102006039462 A1
- EP 1927394 A1
- US 4043507 A
- US 5500162 A
- US 5484559 A
- US 6197073 B
- US 20040007789 A1
- WO 2015014930 A1

**In der Beschreibung aufgeführte Nicht-Patentliteratur**

- **B. C. LIND.** *Materials,* 2012, vol. 5, 1125-1154
- **B.A. MARINKOVIC et al.** *Solid State Sciences,* 2005, vol. 7, 1377-1383
- **Q. LIU et al.** *Applied Surface Science,* 2014, vol. 313, 41-47